**Europäisches Patentamt**

**European Patent Office**

**Office européen des brevets**

(11) Numéro de publication: **0 199 424**
**B1**

# (12) FASCICULE DE BREVET EUROPEEN

(45) Date de publication du fascicule du brevet:
11.07.90

(51) Int. Cl.⁵: **H01L 29/06, H01L 21/74**

(21) Numéro de dépôt: 86200696.2

(22) Date de dépôt: 23.04.86

(54) **Composant semiconducteur du type planar à structure d'anneaux de garde, famille de tels composants et procédé de réalisation.**

(30) Priorité: 26.04.85 FR 8506410

(43) Date de publication de la demande:
29.10.86 Bulletin 86/44

(45) Mention de la délivrance du brevet:
11.07.90 Bulletin 90/28

(84) Etats contractants désignés:
DE FR GB NL

(56) Documents cités:
EP-A- 0 037 764
EP-A- 0 071 915
EP-A- 0 115 093
FR-A- 2 108 781

TOUTE L'ELECTRONIQUE,
no. 460, janvier 1981, page 10, Paris, FR; "Moose: un nouveau procédé bipolaire pour les transistors à fort courant"

(73) Titulaire: PHILIPS COMPOSANTS, 117, quai du Président Roosevelt, F-92130 Issy les Moulineaux(FR)
(84) Etats contractants désignés: FR

(73) Titulaire: N.V. Philips' Gloeilampenfabrieken, Groenewoudseweg 1, NL-5621 BA Eindhoven(NL)
(84) Etats contractants désignés: DE GB NL

(72) Inventeur: Nguyen, Minh-Chau, SOCIETE CIVILE S.P.I.D. 209, rue de l'Université, F-75007 Paris(FR)

(74) Mandataire: Pinchon, Pierre et al, Société Civile S.P.I.D. 209 rue de l'Université, F-75007 Paris(FR)

ACTORUM AG

## Description

La présente invention concerne un procédé de réalisation d'une famille de composants chaque composant semiconducteur comportant un substrat d'un premier type de conductivité présentant une forte concentration de dopage co, une première couche épitaxiale superficielle dudit premier type de conductivité et de concentration de dopage c < co, une zone superficielle adjacente, d'un second type de conductivité opposé au premier, formant avec ladite couche épitaxiale superficielle une jonction planar pn principale présentant sur la plus grande partie de sa surface une profondeur de jonction xj, et une structure d'anneaux de garde flottants dudit second type de conductivité et chaque composant de la famille étant défini par une tension maximale de fonctionnement V.

L'invention trouve une application particulièrement avantageuse dans le domaine des dispositifs tels que diodes de redressement, transistors à effet de champ, transistors bipolaires, thyristors, et notamment les dispositifs de puissance fonctionnant à des tensions élevées.

Un composant semiconducteur conforme à la description ci-dessus est décrit dans la demande de brevet européen n°0 115 093. Ce composant est constitué d'une jonction "planar" principale entourée d'anneaux de garde permettant d'augmenter la tension de claquage au voisinage de la surface de la couche épitaxiale superficielle déposée directement sur le substrat fortement dopé. L'épaisseur et la concentration c de cette couche sont déterminées de façon que la tension de claquage à travers la couche soit supérieure à la tension maximale de fonctionnement V et aussi que la résistance à l'état passant soit minimale. La structure des anneaux de garde, c'est à dire leur nombre, leur largeur et leur distance, est calculée, de façon classique, en fonction de la profondeur xj de la jonction p-n principale, de la concentration c de la couche épitaxiale et de la tension maximale de fonctionnement V souhaitée. Cette structure est reproduite sur un masque de dopage servant à réaliser simultanément la jonction p-n principale et les anneaux de garde flottants.

Donc, à chaque composant semiconducteur particulier correspond un masque spécifique, ce qui multiplie considérablement le nombre de masques lorsque l'on fabrique une grande variété de tels composants. C'est l'objet de la présente invention de proposer un composant semiconducteur conforme au préambule qui pourrait être adapté à une structure d'anneaux de garde donnée.

En effet, selon la présente invention, définie dans les revendications 1 et 2, un composant semiconducteur comportant un substrat d'un premier type de conductivité présentant une forte concentration de dopage co, une première couche épitaxiale superficielle dudit premier type de conductivité et de concentration de dopage c<co, une zone superficielle adjacente, d'un second type de conductivité opposé au premier, formant avec ladite couche épitaxiale superficielle une jonction planar pn principale présentant sur la plus grande partie de sa surface une profondeur de jonction xj, et une structure d'anneaux de garde flottants dudit second type de conductivité est remarquable en ce qu'entre ledit substrat et ladite première couche épitaxiale, est interposée une seconde couche épitaxiale ayant une concentration de dopage c' telle que co > c' > c.

Ainsi, en ajustant l'épaisseur de la couche superficielle, la concentration c' de la deuxième couche épitaxiale ainsi que son épaisseur, il est possible, pour une configuration d'anneaux donnée, de concevoir un composant semiconducteur fonctionnant à la tension maximale de fonctionnement désirée et avec une résistance à l'état passant optimale.

C'est le cas en particulier lorsque l'on désire réaliser une famille de composants du même type, présentant des tensions maximales de fonctionnement différentes. Alors, selon l'invention, une famille de composants semiconducteurs du type "planar" comportant un substrat fortement dopé et une couche épitaxiale superficielle de concentration de porteurs c, dans laquelle sont réalisées une jonction p-n principale de profondeur xj et une structure d'anneaux de garde flottants, chaque composant de la famille étant défini par une tension maximale de fonctionnement V, est remarquable en ce que, une structure particulière d'anneaux de garde flottants ayant été déterminée pour un autre composant du même type, dit composant de référence, extérieur à la famille, constitué d'une couche épitaxiale unique d'épaisseur $e_o$ et de concentration c, et présentant une tension maximale de fonctionnement $V_m$ supérieure à celles de tous les composants de la famille, chaque composant de la famille présente également, d'une part, ladite structure particulière d'anneaux de garde pour structure d'anneaux de garde, et, d'autre part, entre le substrat et la couche épitaxiale superficielle, une deuxième couche épitaxiale de concentration de porteurs c', supérieure à c, la somme de l'épaisseur e de la couche épitaxiale superficielle et de l'épaisseur e' de la deuxième couche épitaxiale étant au plus égale à l'épaisseur $e_o$.

L'invention consiste donc à définir une structure d'anneaux unique pour tous les composants de la famille qui peuvent alors être réalisés à l'aide d'un seul masque, avec les avantages évidents d'industrialisation que cela procure.

La détermination de la concentration c' et des épaisseurs e et e' est conduite, notamment, selon un premier procédé de réalisation de ladite famille de composants qui, conformément à l'invention, est remarquable en ce que, pour ledit composant de référence, on calcule, dans le cas d'une couche épitaxiale unique de façon que la tension de claquage à travers la couche soit au moins égale à la tension maximale de fonctionnement $V_m$ et que la résistance $R_{on}$ à l'état passant soit minimale, et en ce qu', ensuite, on détermine ladite structure particulière d'anneaux de garde flottants associée à la jonction p-n principale de profondeur xj, et en ce que, pour chaque composant de la famille, on calcule les épaisseurs e et e' en maintenant e + e' = $e_o$, et la concentration c', de manière que la tension de claquage soit au moins égale à la tension nominale de fonctionnement V et que la résistance $R_{on}$ à l'état passant soit minimale.

Ce procédé a l'avantage d'être simple à mettre en oeuvre dans la mesure où tous les composants de la famille ont la même épaisseur totale quant à leurs couches épitaxiales et donc correspondent à une opération d'épitaxie standard. Cependant, les composants obtenus par ce procédé n'ont pas une résistance $R_{on}$ optimale du fait que l'épaisseur totale $e_0$ est en général surdimensionnée, notamment pour ceux des composants qui ont une faible tension maximale de fonctionnement. Pour éviter cet inconvénient on a recours à un deuxième procédé selon l'invention, remarquable en ce que, pour ledit composant de référence, on calcule, dans le cas d'une structure plane, l'épaisseur $e_0$ et la concentration c de la couche épitaxiale unique de façon que la tension de claquage à travers la couche soit au moins égale à la tension maximale de fonctionnement $V_m$ et que la résistance $R_{on}$ à l'état passant soit minimale, et en ce qu',ensuite, on détermine ladite structure particulière d'anneaux de garde flottants associée à la jonction p-n principale de profondeur $x_j$, et en ce que, pour chaque composant de la famille, on calcule, d'abord, la concentration c' et une épaisseur totale $e'_0$, qui pour une seule couche épitaxiale de concentration c' en structure plane, permettent d'obtenir une tension de claquage au moins égale à la tension maximale de fonctionnement V et une résistance $R_{on}$ à l'état passant minimale, et en ce qu'on fixe une valeur de l'épaisseur e au moins égale à la distance $d_1$ entre la jonction principale et le premier anneau de garde, l'épaisseur e' étant alors prise égale à $e'_0 - e$.

La description qui va suivre en regard des dessins annexés, donnés à titre d'exemples non limitatifs, fera bien comprendre en quoi consiste l'invention et comment elle peut être réalisée.

La figure 1 montre en coupe partielle un composant semiconducteur selon l'invention.

La figure 2 est une vue en coupe d'un composant de référence et de deux composants appartenant à deux familles réalisées, à partir du composant de référence, selon deux procédés conformes à l'invention.

La figure 3 donne sur une vue en coupe la définition des paramètres d'une structure d'anneaux de garde.

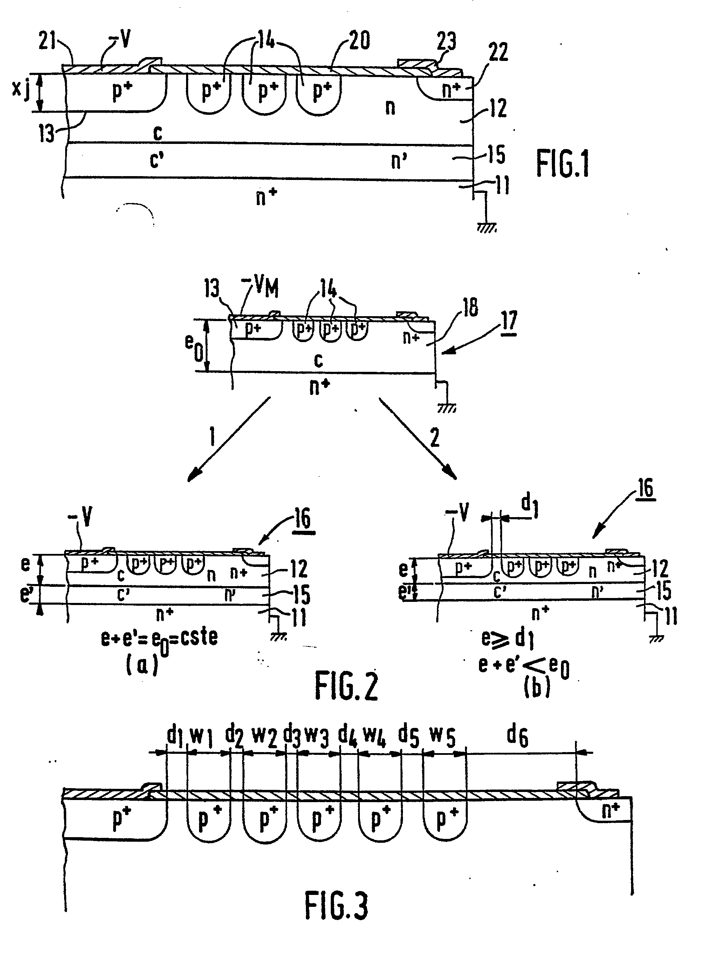

La figure 1 est une vue en coupe partielle d'un composant semiconducteur du type "planar", comportant un substrat 11 fortement dopé, ici de conductivité n+, constituant par exemple le drain d'un transistor MOS, et une couche épitaxiale superficielle 12 de concentration de porteur c, de conductivité n dans le cas de la figure 1. Dans cette couche épitaxiale 12 sont réalisées une jonction p-n 13 principale de profondeur $x_j$ et une structure 14 d'anneaux de garde flottants qui permettent d'éviter le claquage en surface lorsque la tension de polarisation qui bloque la jonction p-n 13 augmente, la région d'appauvrissement traverse successivement chacun des anneaux avant que la tension de claquage soit atteinte. La couche épitaxiale superficielle 12 est revêtue en partie d'une couche d'oxyde 20. La zone de surface correspondant à la jonction principale 13 est recouverte d'une électrode métallique 21 à laquelle est appliquée une tension négative -V élevée par rapport à la couche 12 de façon à polariser la jonction p-n 13. Une sécurité supplémentaire est obtenue grâce à un anneau n+ 22 disposé à la périphérie du cristal de manière à empêcher la région d'appauvrissement d'atteindre le bord du cristal. Une électrode flottante 23 recouvre partiellement l'anneau 22 et la couche d'oxyde 20.

Comme on peut le voir à la figure 1, le composant semiconducteur comporte également, entre le substrat 11 et la couche épitaxiale superficielle 12, une deuxième couche épitaxiale 15 de concentration de porteurs c'. Cette configuration à deux couches épitaxiales de concentrations différentes permet, en donnant aux concentrations et aux épaisseurs des couches des valeurs adéquates, de réaliser un composant ayant une tension de claquage donnée et une résistance à l'état passant $R_{on}$ minimale, lorsqu'une structure d'anneaux de garde flottants est imposée. En particulier, on peut ainsi envisager de n'utiliser qu'un seul masque pour fabriquer une famille de composants semblables, ne différant entre eux que par la valeur de leur tension maximale de fonctionnement V. Dans ce cas, comme l'indique la figure 2, une structure particulière d'anneaux de garde flottants est déterminée pour un autre composant du même type, dit composant 17 de référence, extérieur à la famille, constitué d'une couche épitaxiale unique 18 d'épaisseur $e_0$ et de concentration c, et présentant une tension maximale de fonction $V_m$ supérieure à celles de tous les composants de la famille. Alors, chaque composant 16 de la famille présente également, d'une part, la structure particulière d'anneaux de garde, et, d'autre part, conformément à la figure 1, une deuxième couche épitaxiale 15 située entre le substrat 11 et la couche superficielle 12. Cette deuxième couche 15 a une concentration de porteurs c', supérieure à c, et son épaisseur e' est telle que la somme e + e' est au plus égale à $e_0$.

La figure 2(a) montre un composant 16 de la famille réalisé selon un premier procédé qui consiste en ce qu'on calcule, d'abord, pour le composant 17 de référence, dans le cas d'une structure plane, l'épaisseur $e_0$ et la concentration c de la couche épitaxiale unique 18 de façon que la tension de claquage à travers la couche 12 soit au moins égale à la tension maximale de fonctionnement $V_m$ et que la résistance $R_{on}$ à l'état passant soit minimale. On détermine ensuite ladite structure particulière d'anneaux de garde flottants associée à la jonction p-n principale 13 de profondeur $x_j$. Puis pour, chaque composant 16 de la famille, on calcule les épaisseurs e et e' en maintenant e + e' = $e_0$, et la concentration c', de manière que la tension de claquage soit au moins égale à la tension maximale de fonctionnement V et que la résistance $R_{on}$ à l'état passant soit minimale.

Pour ces calculs qui sont à la portée de l'homme du métier, on se réfère par exemple à la demande de brevet européen n° 115 093 aux pages 10 et 11, ainsi qu'aux publications qui y sont décrites.

5      EP 0 199 424 B1      6

La Demanderesse a défini, par exemple, un composant de référence ayant une tension maximale de fonctionnement $V_m$ égale à 800 V, par paramètres suivants :

$x_j = 6 \ \mu m \quad e_o = 80 \ \mu m \quad c = 10^{14} \ cm^{-3}$

et la structure d'anneaux suivante (voir figure 3) =

$d_1 = 18 \ \mu m$

$d_2 = 20 \ \mu m$

$d_3 = 22 \ \mu m \quad W_1 = W_2 = W_3 = W_4 = 10 \ \mu m$

$d_4 = 25 \ \mu m$

$d_5 = 29 \ \mu m \quad W_5 = 7 \mu m$

$d_6 = 44 \ \mu m$

Cette même structure d'anneaux peut être utilisée pour réaliser un composant de tension maximale de fonctionnement de 500 V défini par :

$c' = 2.10^{14} \ cm^{-3} \quad e = 20 \ \mu m \quad e' = 60 \ \mu m$

La durée totale de l'épitaxie étant la même dans les deux cas.

Le composant semiconducteur 16 de la figure 2 (b) est obtenu selon un deuxième procédé dans lequel, après avoir déterminé la concentration c et la structure d'anneaux de garde pour le composant 17 de référence de la même façon que pour le premier procédé, on calcule d'abord, pour chaque composant 16 de la famille, la concentration c' et une épaisseur totale $e'_o$ qui, pour une seule couche épitaxiale de concentration c' en structure plane, permettent d'obtenir une tension de claquage au moins égale à la tension maximale de fonctionnement V et une résistance $R_{on}$ à l'état passant minimale. Ensuite, on fixe une valeur de l'épaisseur e au moins égale à la distance $d_1$ entre la jonction principale 13 et le premier anneau de garde, l'épaisseur e' étant alors prise égale à $e'_o$ - e.

Ce procédé de réalisation permet en général d'obtenir des couches moins épaisses et donc une résistance à l'état passant encore plus faible que par le premier procédé.

En particulier on trouve qu'avec la même structure d'anneaux, on peut réaliser un composant de tension maximale de fonctionnement de 500 V avec les paramètres suivants:

$c = 10^{14} \ cm^{-3} \quad c' = 2.10^{14} cm^{-3}$

$e = 40 \ \mu m \quad e' = 15 \ \mu m$

L'épaisseur totale de ce composant est de 55 $\mu m$ au lieu de 80 dans l'exemple précédent et sa résistance à l'état passant est plus faible.

## Revendications

1. Procédé de réalisation d'une famille de composants semiconducteurs comportant un substrat d'un premier type de conductivité présentant une forte concentration de dopage co, une première couche épitaxiale superficielle dudit premier type de conductivité et de concentration de dopage c < co, une zone superficielle adjacente d'un second type de conductivité opposé au premier, formant avec ladite couche épitaxiale superficielle une jonction planar pn principale présentant sur la plus grande partie de sa surface une profondeur de jonction xj, et une structure d'anneaux de garde flottants dudit second type de conductivité, tandis qu'entre ledit substrat et ladite première couche épitaxiale, est interposée une seconde couche épitaxiale, du premier type de conductivité, ayant une concentration de dopage c' telle que co > c' > c, ladite famille étant telle que, chacun de ses composants étant défini par une tension maximale de fonctionnement V particulière, tous les composants de la famille ont la même structure d'anneaux de garde, ladite structure d'anneaux de garde ayant été déterminée pour un composant de référence extérieur à la famille, constitué d'une couche épitaxiale unique d'épaisseur $e_o$ et de concentration c et présentant une tension maximale de fonctionnement $V_m$ supérieure à celles de tous les composants de la famille, la somme de l'épaisseur e de la couche épitaxiale superficielle et de l'épaisseur e' de la deuxième couche épitaxiale de tous les composants de la famille étant au plus égale à l'épaisseur $e_o$, procédé dans lequel, pour ledit composant de référence, on calcule, dans le cas d'une structure plane, l'épaisseur $e_o$ et la concentration c de la couche épitaxiale unique de façon que la tension de claquage à travers la couche soit au moins égale à la tension maximale de fonctionnement $V_m$ et que la résistance $R_{on}$ à l'état passant soit minimale, et en ce que, ensuite, on détermine ladite structure particulière d'anneaux de garde flottants associée à la jonction p-n principale de profondeur $x_j$, et en ce que, pour chaque composant de la famille, on calcule les épaisseurs e et e' en maintenant $e+e' = e_o$, et la concentration c', de manière que la tension de claquage soit au moins égale à la tension maximale de fonctionnement V et que la résistance $R_{on}$ à l'état passant soit minimale.

2. Procédé de réalisation d'une famille de composants semiconducteurs comportant un substrat d'un premier type de conductivité présentant une forte concentration de dopage co, une première couche épitaxiale superficielle dudit premier type de conductivité et de concentration de dopage c < co, une zone superficielle adjacente d'un second type de conductivité opposé au premier, formant avec ladite couche épitaxiale superficielle une jonction planar pn principale présentant sur la plus grande partie de sa surface une profondeur de jonction xj, et une structure d'anneaux de garde glottants dudit second type de conductivité, tandis qu'entre ledit substrat et ladite première couche épitaxiale, est interposée une seconde couche épitaxiale, du premier type de conductivité, ayant une concentration de dopage c' telle que co > c' > c, ladite famille étant telle que, chacun de ses composants étant défini par une tension maximale de fonctionnement V particulière, tous les composants de la famille ont la même structure d'anneaux de garde, ladite structure d'anneau de garde ayant été déterminée pour un composant de référence extérieur à la famille, constitué d'une couche épitaxiale unique d'épaisseur $e_o$ et de concentration c et présentant une tension maximale de fonctionnement $V_m$ supérieure à celles V de tous les composants de la famille, la somme de l'épaisseur e de la couche épitaxiale superficielle et de l'épaisseur e' de la deuxième couche épitaxiale de tous les composants de la famille étant au plus égale à l'épaisseur $e_o$, procédé dans lequel, pour ledit

4

composant de référence, on calcule, dans le cas d'une structure plane, l'épaisseur $e_0$ et la concentration c de la couche épitaxiale unique de façon que la tension de claquage à travers la couche soit au moins égale à la tension maximale de fonctionnement $V_m$ et que la résistance $R_{on}$ à l'état passant soit minimale, et en ce que, ensuite, on détermine ladite structure particulière d'anneaux de garde flottants associée à la jonction p-n principale de profondeur $x_j$, et en ce que, pour chaque composant de la famille, on calcule, d'abord, la concentration c' et une épaisseur totale $e'_0$, qui pour une seule couche épitaxiale de concentration c' en structure plane, permettent d'obtenir une tension de claquage au moins égale à la tension maximale de fonctionnement V et une résistance $R_{on}$ à l'état passant minimale, et en ce qu'on fixe une valeur de l'épaisseur e au moins égale à la distance $d_1$ entre la jonction principale et le premier anneau de garde, l'épaisseur e' étant alors prise égale à $e'_0 - e$.

**Claims**

1. A method of manufacturing a class of semiconductor devices comprising a substrate of a first conductivity type having a high doping concentration $c_o$, a first epitaxial surface layer of said first conductivity type and having a lower doping concentration c < $c_o$, an adjacent surface zone of the second conductivity type opposite to the first conductivity type forming with said epitaxial surface layer a main planar pn junction having over the major part of its area a junction depth $x_j$, and a structure of floating guard rings of said second conductivity type, characterized in that between said substrate and said first epitaxial layer there is provided a second epitaxial layer of the first conductivity type having a doping concentration c' such that $c_o$ > c' > c, the said class being such that each device of the class being defined by a particular maximum operating voltage V, all the devices of the class have the same structure of guard rings, the said structure of guard rings having been determined for a reference device not belonging to the class, constituted by a single epitaxial layer having a thickness $e_0$ and a concentration c and presenting a maximum operating voltage $V_m$ exceeding that of all the devices of the class, the sum of the thickness $e$ of the epitaxial surface layer and of the thickness $e'$ of the second epitaxial layer of all the devices of the class being at most equal to the thickness $e_0$, characterized in that for the said reference device, in the case of a planer structure, the thickness $e_0$ and the concentration $c$ of the single epitaxial layer are calculated in such a manner that the breakdown voltage through the layer is at least equal to the maximum operating voltage $V_m$ and that the resistance $R_{on}$ in the "on" state is minimal, in that then the particular structure of floating guard rings associated with the main pn junction having a depth $x_j$ is determined, and in that for each component of the class the thicknesses $e$ and $e'$, whilst maintaining e + e' = $e_0$, and the concentration $c'$ are calculated in such a manner that the breakdown voltage is at least equal to the maximum operating voltage V and that the resistance $R_{on}$ in the "on" state is minimal.

2. A method of manufacturing a class of semiconductor devices comprising a substrate of a first conductivity type having a high doping concentration $c_o$, a first epitaxial surface layer of said first conductivity type and having a lower doping concentration c < $c_o$, an adjacent surface zone of the second conductivity type opposite to the first conductivity type forming with said epitaxial surface layer a main planar pn junction having over the major part of its area a junction depth $x_j$, and a structure of floating guard rings of said second conductivity type, characterized in that between said substrate and said first epitaxial layer there is provided a second epitaxial layer of the first conductivity type having a doping concentration c' such that $c_o$ > c' > c, the said class being such that each device of the class being defined by a particular maximum operating voltage V, all the devices of the class have the same structure of guard rings, the said structure of guard rings having been determined for a reference device not belonging to the class, constituted by a single epitaxial layer having a thickness $e_0$ and a concentration c and presenting a maximum operating voltage $V_m$ exceeding that of all the devices of the class, the sum of the thickness $e$ of the epitaxial surface layer and of the thickness $e'$ of the second epitaxial layer of all the devices of the class being at most equal to the thickness $e_0$, characterized in that for the said reference device, in the case of a planar structure, the thickness $e_0$ and the concentration $c$ of the single epitaxial layer are calculated in such a manner that the breakdown voltage through the layer is at least equal to the maximum operating voltage $V_m$ and that the resistance $R_{on}$ in the "on" state is minimal, in that then the said particular structure of floating guard rings associated with the main pn junction having a depth $x_j$ is determined, in that for each device of the class first the concentration $c'$ and an overall thickness $e'_0$ are calculated, which permit for a single epitaxial layer having a concentration $c'$ and a planar structure of obtaining a breakdown voltage at least equal to the maximum operating voltage V and a minimum resistance $R_{on}$ in the "on" state, and in that a value of the thickness $e$ at least equal to the distance $d_1$ between the main junction and the first guard ring is fixed, the thickness e' then being chosen equal to $e'_0$-e.

**Patentansprüche**

1. Verfahren zum Herstellen einer Klasse von Halbleiterbauteilen mit einem Substrat von einem ersten Leitungstyp mit einer hohen Dotierungskonzentration co, einer ersten Epitaxialoberflächenschicht vom genannten ersten Leitungstyp und mit einer Dotierungskonzentration c < co, einer an die Oberfläche grenzenden Zone von einem zweiten dem ersten entgegengesetzten Leitungstyp, die mit der genannten Epitaxialoberflächenschicht einen planaren PN-Hauptübergang bildet, der über den größten Teil der Oberfläche eine Übergangstiefe $x_j$ aufweist, sowie eine schwebende Schutzringstruktur vom genannten zweiten Leitungstyp, wobei zwischen dem genannten Substrat und der genannten ersten Epitaxialschicht eine zweite Epitaxialschicht vom ersten Leitungstyp vorgesehen ist mit einer derartigen Dotierungskonzentration $c'$, daß $co > c' > c$ ist, wobei diese Klasse derart ist, daß jedes Bauteile durch eine maximale spezifische Funktionsspannung $V$ definiert ist, wobei alle Bauteile der Klasse die gleiche Schutzringstruktur haben, die für einen Bezugsbauteil außerhalb der Klasse bestimmt worden ist, der aus einer einzigen Epitaxialschicht mit einer Dicke $e_0$ und mit einer Konzentration $c$ besteht und eine maximale Betriebsspannung $V_m$ größer als die aller anderen Bauteile der Klasse hat, wobei die Summe der Dicke $e$ der epitaxialen Oberflächenschicht und der Dicke $e'$ der zweiten Epitaxialschicht aller Bauteile der Klasse höchstens der Dicke $e_0$ entspricht, wobei in diesem Verfahren für den genannten Bezugsbauteil im Falle einer flachen Struktur die Dicke $e_0$ und die Konzentration $c$ der einzigen Epitaxialschicht derart berechnet wird, daß die Durchbruchspannung durch die Schicht mindestens der maximalen Betriebsspannung $V_m$ mindestens entsprechen soll und wobei der Widerstand $R_{on}$ im leitenden Zustand minimal sein soll und wobei danach die genannte spezifische schwebenden Schutzringstruktur bestimmt wird, die dem Haupt-PN-Übergang mit einer Tiefe $x_j$ zugeordnet ist, und wobei für jeden Bauteil der Klasse die Dicken $e$ und $e'$ unter Beibehaltung von $e+e'=e_0$ bestimmt werden, ebenso wie die Konzentration $c'$, derart, daß die Durchbruchspannung der maximalen Betriebsspannung $V$ mindestens entsprechen soll und daß der Widerstand $R_{on}$ im leitenden Zustand minimal sein soll.

2. Verfahren zum Herstellen einer Klasse von Halbleiterbauteilen mit einem Substrat von einem ersten Leitungstyp mit einer hohen Dotierungskonzentration $co$, einer ersten Epitaxialoberflächenschicht vom genannten ersten Leitungstyp und mit einer Dotierungskonzentration $c < co$, einer an die Oberfläche grenzenden Zone von einem zweiten dem ersten entgegengesetzten Leitungstyp, die mit der genannten Epitaxialoberflächenschicht einen planaren PN-Hauptübergang bildet, der über den größten Teil der Oberfläche eine Übergangstiefe $x_j$ aufweist, sowie eine schwebende Schutzringstruktur vom genannten zweiten Leitungstyp, wobei zwischen dem genannten Substrat und der genannten ersten Epitaxialschicht eine zweite Epitaxialschicht vom ersten Leitungstyp vorgesehen ist mit einer derartigen Dotierungskonzentration $c'$, daß $co > c' > c$ ist, wobei diese Klasse derart ist, daß jeder der Bauteile durch eine maximale spezifische Betriebsspannung $V$ definiert ist, wobei alle Bauteile der Klasse die gleiche Schutzringstruktur haben, die für einen Bezugsbauteil außerhalb der Klasse bestimmt worden ist, der aus einer einzigen Epitaxialschicht mit einer Dicke $e_0$ und mit einer Konzentration $c$ besteht und eine maximale Betriebsspannung $V_m$ größer als die aller anderen Bauteile der Klasse hat, wobei die Summe der Dicke $e$ der epitaxialen Oberflächenschicht und der Dicke $e'$ der zweiten Epitaxialschicht aller Bauteile der Klasse höchstens der Dicke $e_0$ entspricht, wobei in diesem Verfahren für den genannten Bezugsbauteil im Falle einer flachen Struktur die Dicke $e_0$ und die Konzentration $c$ der einzigen Epitaxialschicht derart berechnet wird, daß die Durchbruchspannung durch die Schicht der maximalen Betriebsspannung $V_m$ entsprechen soll und wobei der Widerstand $R_{on}$ im leitenden Zustand minimal sein soll und wobei danach die genannte spezifische schwebenden Schutzringstruktur bestimmt wird, die dem Haupt-PN-Übergang mit einer Tiefe $x_j$ zugeordnet ist, und wobei für jeden Bauteil der Klasse zunächst die Konzentration $c'$ und eine Gesamtdicke $e'_0$ berechnet wird, durch die es für eine einzige Epitaxialschicht mit einer Konzentration $c'$ in Planarstruktur möglich ist eine Durchbruchspannung zu erhalten, die der maximalen Betriebsspannung $V$ mindestens entspricht, sowie einen Widerstand $R_{on}$ im minimalen leitenden Zustand, und wobei ein Wert der Dicke $e$ wenigstens gleich dem Abstand $d_1$ zwischen dem Hauptübergang und dem ersten Schutzring festgelegt wird, wobei die Dicke $e'$ daraufhin gleich $e'_0$-$e$ genommen wird.

FIG.1

$e + e' = e_0 = cste$
( a )

$e \geqslant d_1$
$e + e' \leqslant e_0$
(b)

FIG.2

FIG.3